# EUROPEAN PATENT APPLICATION

(11) **EP 2 001 069 A2**
(43) Date of publication of application: **10.12.2008**
(21) Application number: 08251797.0
(22) Date of filing: 23.05.2008
(51) Int. Cl.: H01M 8/02

(54) **Printed circuit board and fuel cell**

(30) Priority: 31.05.2007 JP 2007145953
(71) Applicant: Nitto Denko Corporation, Ibaraki-shi, Osaka 567-8680 (JP)
(72) Inventor: Yamazaki, Taiki, c/o Nitto Denko Corporation, Ibaraki-shi, Osaka 567-8680 (JP); Sueyoshi, Taiki, c/o Nitto Denko Corporation, Ibaraki-shi, Osaka 567-8680 (JP)
(74) Representative: Gill, Stephen Charles

(57) **Abstract**

An FPC board includes a base insulating layer made of polyimide, for example. A conductor layer made of copper, for example, is formed on one surface of the base insulating layer. The conductor layer is composed of a pair of rectangular collector portions and extraction conductor portions extending in long-sized shapes from the collector portions. A coating layer is formed on the base insulating layer so as to coat the conductor layer. The coating layer is formed so as to coat the collector portions and the extraction conductor portions of the conductor layer. The coating layer is made of a resin composition containing carbon.

## Description

### BACKGROUND OF THE INVENTION

### Field of the Invention

The present invention relates to a printed circuit board and a fuel cell using the same.

### Description of the Background Art

Batteries that are small in size and have high capacitance are desired for mobile equipment such as cellular telephones. Therefore, fuel cells capable of providing high energy densities compared to conventional batteries such as lithium secondary batteries have been developed. Examples of the fuel cells include a direct methanol fuel cell.

In the direct methanol fuel cell, methanol is decomposed by a catalyst, forming hydrogen ions. The hydrogen ions are reacted with oxygen in the air to generate electrical power. In this case, chemical energy can be converted into electrical energy with extremely high efficiency, so that significantly high energy density can be obtained.

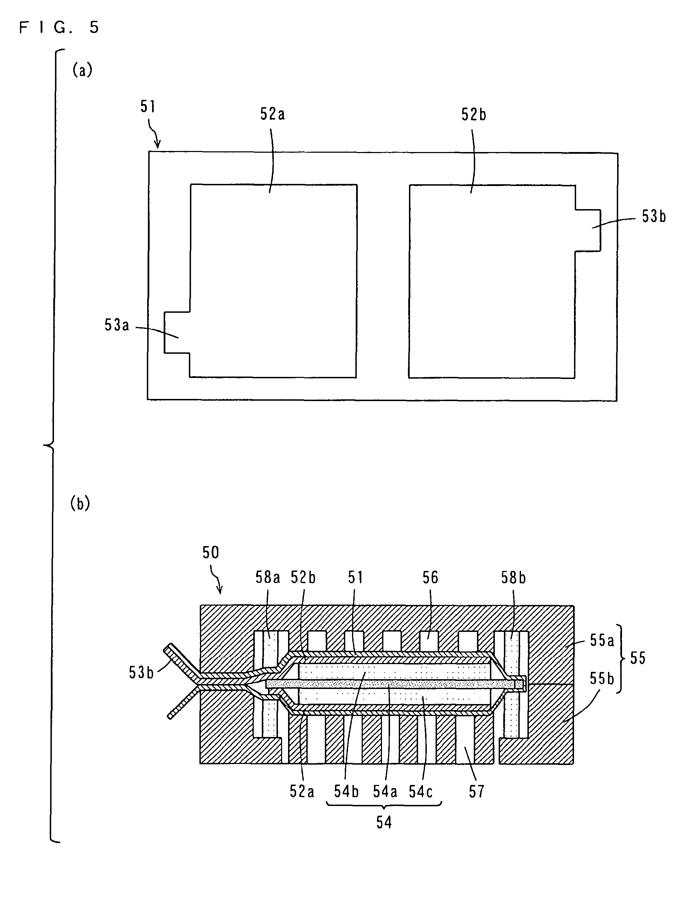

A flexible printed circuit board (herein after abbreviated as an FPC board), for example, is provided within such a direct methanol fuel cell as a collector circuit (see JP 2004-200064 A, for example). Here, a configuration of the conventional fuel cell is described using Fig. 5. Fig. 5 (a) is a plan view of the FPC board used in the conventional fuel cell, and Fig. 5 (b) is a sectional view showing the configuration of the conventional fuel cell.

As shown in Fig. 5 (a), a pair of conductor layers 52a, 52b is formed on one surface of the FPC board 51. In addition, extraction electrodes 53a, 53b are provided so as to extend out of the conductor layers 52a, 52b, respectively.

As shown in Fig. 5 (b), a fuel cell 50 is constituted by the FPC board 51, a film electrode junction 54 and a housing 55. The film electrode junction 54 is composed of a polyelectrolyte film 54a, a fuel electrode 54b and an air electrode 54c. The fuel electrode 54b is formed on one surface of the polyelectrolyte film 54a, and the air electrode 54c is formed on the other surface of the polyelectrolyte film 54a. The housing 55 is composed of a pair of half portions 55a, 55b. The half portion 55a is provided with fuel passages 56 into which fuel (methanol) flows, and the half portion 55b is provided with air passages 57 into which air flows.

The FPC board 51 is bent with its one surface on which the conductor layers 52a, 52b are formed as an inner side. The film electrode junction 54 is sandwiched between the conductor layers 52a, 52b of the bent FPC board 51. Gaskets 58a, 58b are disposed in the periphery of the FPC board 51. In this state, the folded FPC board 51 excluding portions of the extraction electrodes 53a, 53b is housed in the housing 55 composed of the half portions 55a, 55b. Various types of external circuits such as electronic components are electrically connected to the extraction electrodes 53a, 53b that project from the housing 55.

In this fuel cell 50, methanol is supplied to the fuel electrode 54b of the film electrode junction 54 through the fuel passages 56 of the half portion 55a. Moreover, air is supplied to the air electrode 54c of the film electrode junction 54 through the air passages 57 of the half portion 55b. In this case, methanol is decomposed into hydrogen ions and carbon dioxide by a catalyst to form electrons in the fuel electrode 54b.

The hydrogen ions decomposed from the methanol pass through the polyelectrolyte film 54a to reach the air electrode 54c, and then react with oxygen in the air supplied to the air electrode 54c on the catalyst. Thus, the electrons are consumed while water is formed in the air electrode 54c. This causes the electrons to move between the conductor layers 52a, 52b of the FPC board 51 and supplies electrical power to the external circuits.

Generally, copper is used as the conductor layers 52a, 52b of the FPC board 51. Therefore, the conductor layers 52a, 52b are affected by acid of methanol and the like supplied to the fuel cell 50, resulting in being corroded in some cases.

### SUMMARY OF THE INVENTION

An object of the present invention is to provide a printed circuit board in which corrosion of a conductor layer can be prevented and a fuel cell including the same.
(1) According to a first aspect of the present invention, a printed circuit board used for a fuel cell includes an insulating layer, a conductor layer that is provided on the insulating layer and has a predetermined pattern, and a coating layer that includes carbon and coats a surface of the conductor layer.
   In this printed circuit board, the surface of the conductor layer provided on the insulating layer is coated with the coating layer. The coating layer includes carbon, thereby having electrical conductivity. In this case, in the fuel cell using this printed circuit board, corrosion of the conductor layer can be prevented without inhibiting a collecting action of the conductor layer even in a state where acid of methanol and the like supplied as fuel is in contact with the printed circuit board.
   In addition, since it is not necessary to use an expensive material such as Au (gold), corrosion of the conductor layer can be prevented at low cost. Furthermore, ion migration of the conductor layer can be prevented by the coating layer.
(2) The coating layer may include a resin composition containing carbon. In this case, the surface of the conductor layer can be easily and reliably coated with the coating layer.
(3) The insulating layer may have one surface and the other surface while including, on the one surface, first and second regions that are adjacent to each other and a third region that is adjacent to the first region, the insulating layer can be bent along a bend portion between the first region and the second region such that the first region and the second region face each other, the conductor layer may include a first conductor portion formed in the first region of the insulating layer, a second conductor portion formed in the second region of the insulating layer, a first extraction portion formed so as to extend from the first conductor portion to reach the third region of the insulating layer, and a second extraction portion formed so as to extend from the second conductor portion to reach the third region of the insulating layer, and the coating layer may include a first coating portion that coats the first conductor portion and the first extraction portion, and a second coating portion that coats the second conductor portion and the second extraction portion.
   When this printed circuit board is used in the fuel cell, the insulating layer is bent at the bend portion between the first region and the second region such that the first region and the second region face each other, and a cell element including a fuel electrode and an air electrode is sandwiched between the first conductor portion and the second conductor portion. In addition, the third region of the insulating layer is outwardly extracted, and at least part of the first extraction portion and at least part of the second extraction portion on the third region of the insulating layer are exposed to the outside.
   In this case, since at least part of the first extraction portion and at least part of the second extraction portion are exposed in proximity to each other in the same plane, the first and second extraction portions can be easily and accurately aligned with and connected to terminals of external circuits. This improves reliability of connection between the fuel cell using this printed circuit board and the external circuits.
   Moreover, in the fuel cell, even in the state where acid of methanol and the like supplied as fuel is in contact with the printed circuit board, the first and second conductor portions and the first and second extraction portions can be prevented from being corroded by the acid without inhibiting the collecting actions of the first and second conductor portions.
(4) A first through hole may be formed so as to penetrate the first region of the insulating layer and the first conductor portion of the conductor layer, and a second through hole may be formed so as to penetrate the second region of the insulating layer and the second conductor portion of the conductor layer.
   In this case, in the fuel cell using this printed circuit board, fuel and air can be supplied to the fuel electrode and the air electrode of the fuel cell through the first and second through holes.
(5) According to another aspect of the present invention, a fuel cell includes a printed circuit board, a cell element, and a housing that houses the printed circuit board and the cell element, wherein the printed circuit board includes an insulating layer having one surface and the other surface while including, on the one surface, first and second regions that are adjacent to each other and a third region that is adjacent to the first region, a first conductor portion formed in the first region of the insulating layer, a second conductor portion formed in the second region of the insulating layer, a first extraction portion formed so as to extend from the first conductor portion to reach the third region of the insulating layer, a second extraction portion formed so as to extend from the second conductor portion to reach the third region of the insulating layer, and a coating layer that includes carbon and coats surfaces of the first and second conductor portions and surfaces of the first and second extraction portions, a bend portion is provided at a boundary between the first region and the second region of the insulating layer, the cell element is arranged between the first and second regions in a state where the first and second regions of the insulating layer of the printed circuit board are bent along the bend portion with the one surface as an inner side, and the third region of the insulating layer is outwardly extracted from the housing such that at least part of the first extraction portion and at least part of the second extraction portion are exposed to the outside of the housing.

In this fuel cell, the printed circuit board and the cell element are housed in the housing. In the printed circuit board, the surfaces of the first and second conductor portions and first and second extraction portions provided on the insulating layer are coated with the coating layer. The coating layer includes carbon, thereby having electrical conductivity.

The insulating layer of the printed circuit board is bent at the bend portion between the first region and the second region such that the first region and the second region face each other. The cell element including a fuel electrode and an air electrode is arranged between the first and second conductor portions on the bent insulating layer. The third region of the insulating layer of the printed circuit board is outwardly extracted from the housing such that at least part of the first extraction portion and at least part of the second extraction portion are exposed to the outside of the housing.

Acid of methanol and the like is supplied to the housing as fuel. In this case, the surface of the conductor layer of the printed circuit board is coated with the coating layer including carbon, so that the conductor layer can be prevented from being corroded by the acid without inhibiting a collecting action of the conductor layer. In addition, since it is not necessary to use an expensive material such as Au (gold), corrosion of the conductor layer can be prevented at low cost. Furthermore, ion migration of the conductor layer can be prevented by the coating layer.

At least part of the first extraction portion and at least part of the second extraction portion of the printed circuit board are exposed in the same plane outside the housing. Thus, the first and second extraction portions can be easily and accurately aligned with and connected to terminals of external circuits. This improves reliability of connection between the fuel cell and the external circuits.

According to another aspect of the present invention, a fuel cell includes a printed circuit board according to the first aspect.

Other features, elements, characteristics, and advantages of the present invention will become more apparent from the following description of preferred embodiments of the present invention with reference to the attached drawings.

### BRIEF DESCRIPTION OF THE DRAWINGS

Fig. 1 is a diagram showing a configuration of a flexible printed circuit board according to the present embodiment;
Fig. 2 is a sectional view for use in explaining steps in a manufacturing method of the flexible printed circuit board;
Fig. 3 is a sectional view for use in explaining steps in the manufacturing method of the flexible printed circuit board;
Fig. 4 is a diagram showing a configuration of a fuel cell using the flexible printed circuit board of Fig. 1; and
Fig. 5 is a diagram showing a fuel cell using a conventional printed circuit board.

### DESCRIPTION OF THE PREFERRED EMBODIMENTS

A printed circuit board and a fuel cell according to an embodiment of the present invention will now be described while referring to drawings. Note that a flexible printed circuit board having flexibility is described as an example of the printed circuit board in the present embodiment.

### (1) Configuration of the flexible printed circuit board

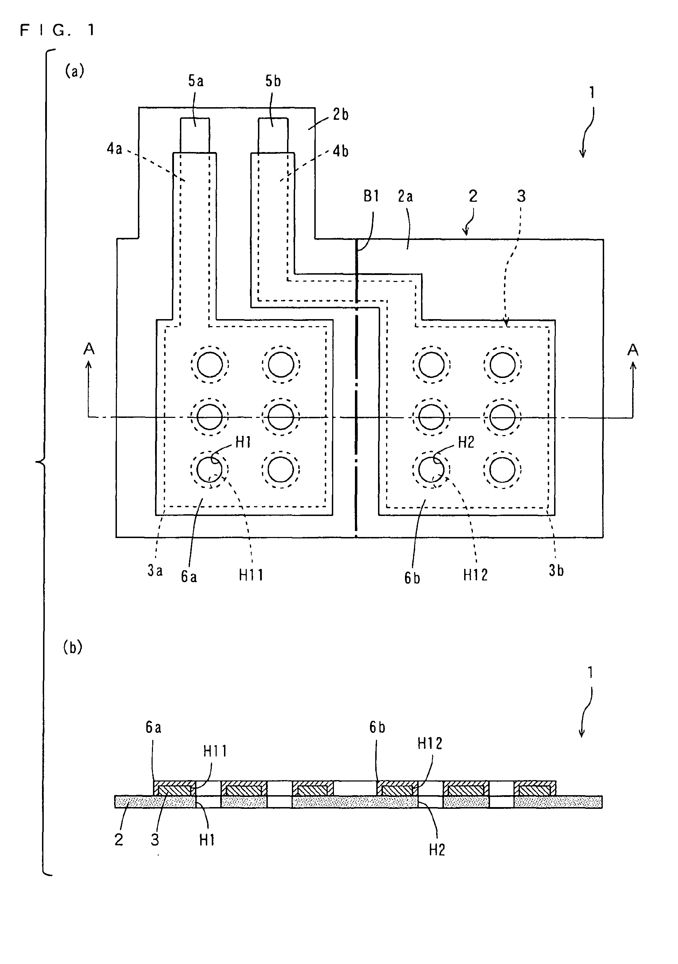

Fig. 1 (a) is a plan view of the flexible printed circuit board according to the present embodiment, and Fig. 1 (b) is a sectional view taken along the line A-A of the flexible printed circuit board of Fig. 1 (a). In the following description, the flexible printed circuit board is abbreviated as the FPC board.

As shown in Fig. 1 (a) and Fig. 1 (b), the FPC board 1 includes a base insulating layer 2 made of polyimide, for example. The base insulating layer 2 is composed of a rectangular first insulating portion 2a and a second insulating portion 2b that outwardly extends from one side of the first insulating portion 2a. Hereinafter, the above-mentioned one side of the first insulating portion 2a and the other one side parallel thereto are referred to as lateral sides, and the other pair of sides vertical to the lateral sides of the first insulating portion 2a are referred to as end sides.

A bend portion B1 is provided in the first insulating portion 2a of the base insulating layer 2 so as to be parallel to the end sides and to divide the first insulating portion 2a into two substantially equal parts. As will be described later, the first insulating portion 2a is bent along the bend portion B1. The bend portion B1 may be a shallow groove with a line shape, a mark with a line shape or the like, for example. Alternatively, there may be nothing at the bend portion B1 if the first insulating portion 2a can be bent at the bend portion B1. The above-mentioned second insulating portion 2b is formed so as to outwardly extend from the lateral side of one region of the first insulating portion 2a with the bend portion B1 as a boundary.

A plurality of (six in this example) openings H1 are formed in the one region of the first insulating portion 2a with the bend portion B1 as the boundary. A plurality of (six in this example) openings H2 are formed in the other region of the first insulating portion 2a with the bend portion B1 as the boundary.

The conductor layer 3 made of copper, for example, is formed on one surface of the base insulating layer 2. The conductor layer 3 is composed of a pair of rectangular collector portions 3a, 3b and extraction conductor portions 4a, 4b extending in long-sized shapes from the collector portions 3a, 3b, respectively.

Each of the collector portions 3a, 3b has a pair of lateral sides parallel to the lateral sides of the first insulating portion 2a and a pair of end sides parallel to the end sides of the first insulating portion 2a. The collector portion 3a is formed in the one region of the first insulating portion 2a with the bend portion B1 as the boundary, and the collector portion 3b is formed in the other region of the first insulating portion 2a with the bend portion B1 as the boundary.

Openings H11 each having a larger diameter than that of the opening H1 are formed in portions, above the openings H1 of the base insulating layer 2, of the collector portion 3a. Openings H12 each having a larger diameter than that of the opening H2 are formed in portions, above the openings H2 of the base insulating layer 2, of the collector portion 3b.

The extraction conductor portion 4a is formed so as to linearly extend from the lateral side of the collector portion 3a to a region on the second insulating portion 2b. The extraction conductor portion 4b is formed so as to extend from the lateral side of the collector portion 3b and bend to a region on the second insulating portion 2b.

Coating layers 6a, 6b are formed on the base insulating layer 2 so as to coat the conductor layer 3. The coating layers 6a, 6b are made of a resin composition containing carbon (carbon black, for example). The coating layer 6a is formed so as to coat the collector portion 3a and the extraction conductor portion 4a of the conductor layer 3, and the coating layer 6b is formed so as to coat the collector portion 3b and the extraction conductor portion 4b of the conductor layer 3. The coating layer 6a is in contact with an upper surface of the base insulating layer 2 in the openings H11 of the collector portion 3a. The coating layer 6b is in contact with the upper surface of the base insulating layer 2 in the openings H12 of the collector portion 3b.

Note that tips of the extraction conductor portions 4a, 4b are exposed without being coated with the coating layers 6a, 6b. Hereinafter, exposed portions of the extraction conductor portions 4a, 4b are referred to as extraction electrodes 5a, 5b.

### (2) Manufacturing method of the FPC board

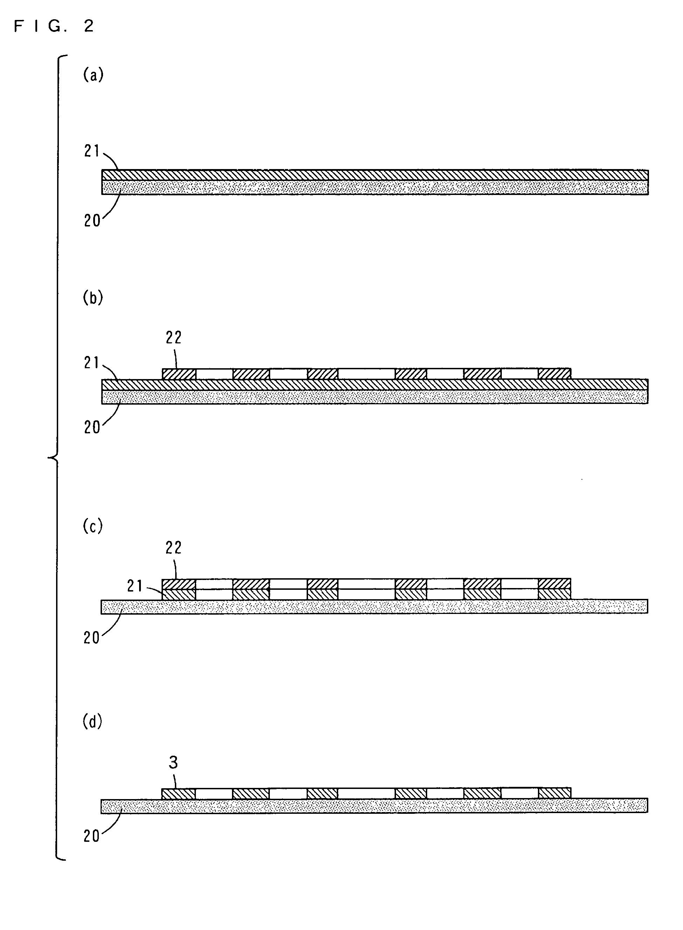

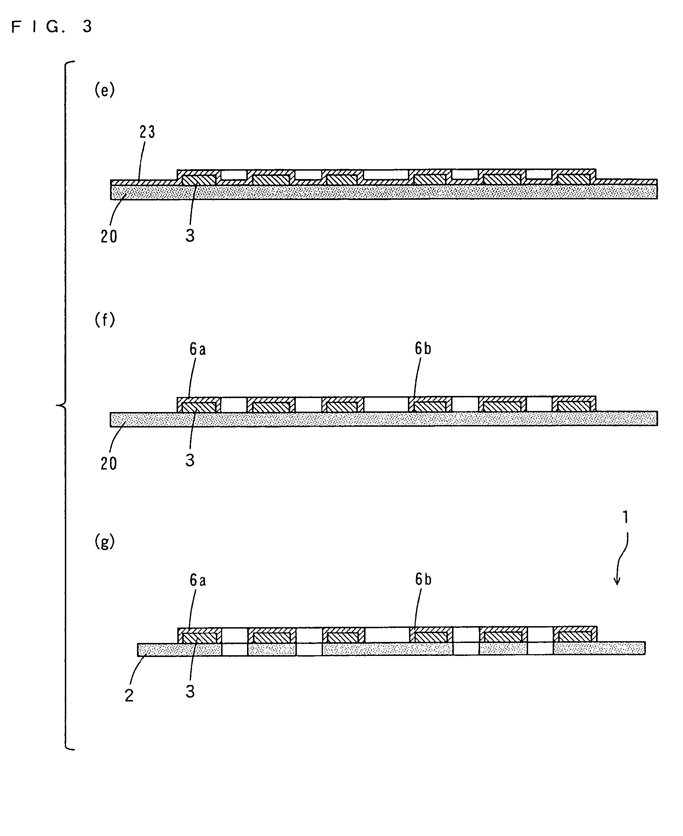

Next, description is made of a manufacturing method of the FPC board 1 shown in Fig. 1. Fig. 2 and Fig. 3 are sectional views for use in explaining steps in the manufacturing method of the FPC board 1.

First, a two-layer base material composed of an insulating film 20 made of polyimide, for example, and a conductor film 21 made of copper, for example, is prepared as shown in Fig. 2 (a). The thickness of the insulating film 20 is 12.5 µm, for example, and the thickness of the conductor film 21 is 12 µm, for example.

Next, an etching resist 22 having a predetermined pattern is formed on the conductor film 21 as shown in Fig. 2 (b). The etching resist 22 is formed by forming a resist film on the conductor film 21 using a dry film resist or the like, exposing the resist film in a predetermined pattern, and then developing the resist film, for example.

Then, a region of the conductor film 21 excluding a region below the etching resist 22 is removed by etching as shown in Fig. 2 (c). The etching resist 22 is subsequently removed by a stripping liquid as shown in Fig. 2 (d). In this way, a conductor layer 3 is formed on the insulating film 20.

Next, a coating film 23 is formed on the conductor layer 3 by applying or laminating a resin composition containing carbon black, for example, as shown in Fig. 3 (e). The thickness of the coating film 23 is 10 µm, for example.

The coating film 23 is subsequently exposed in a predetermined pattern,followed by development,therebyforming the coating layers 6a, 6b as shown in Fig. 3 (f).

Then, the insulating film 20 is cut into predetermined shapes as shown in Fig. 3 (g), so that the FPC board 1 composed of the base insulating layer 2, the conductor layer 3 and the coating layers 6a, 6b is completed.

Note that the thickness of the base insulating layer 2 is preferably 5 to 50 µm, and more preferably 12.5 to 25 µm. The thickness of the conductor layer 3 is preferably 3 to 35 µm, and more preferably 5 to 20 µm. The thickness of the coating layer 6 is preferably 5 to 25 µm, and more preferably 10 to 20 µm.

Although the method of manufacturing the FPC board 1 by a subtractive method is shown in Fig. 2 and Fig. 3, another manufacturing method such as a semi-additive method may be used. In addition, although a case where the coating layers 6a, 6b are formed using an exposure method is shown in Fig. 2 and Fig. 3 as an example, the coating layers 6a, 6b may be formed by forming coating films in a predetermined pattern using a printing technique and then subjecting the coating films to thermal curing treatment.

### (3) The fuel cell using the FPC board

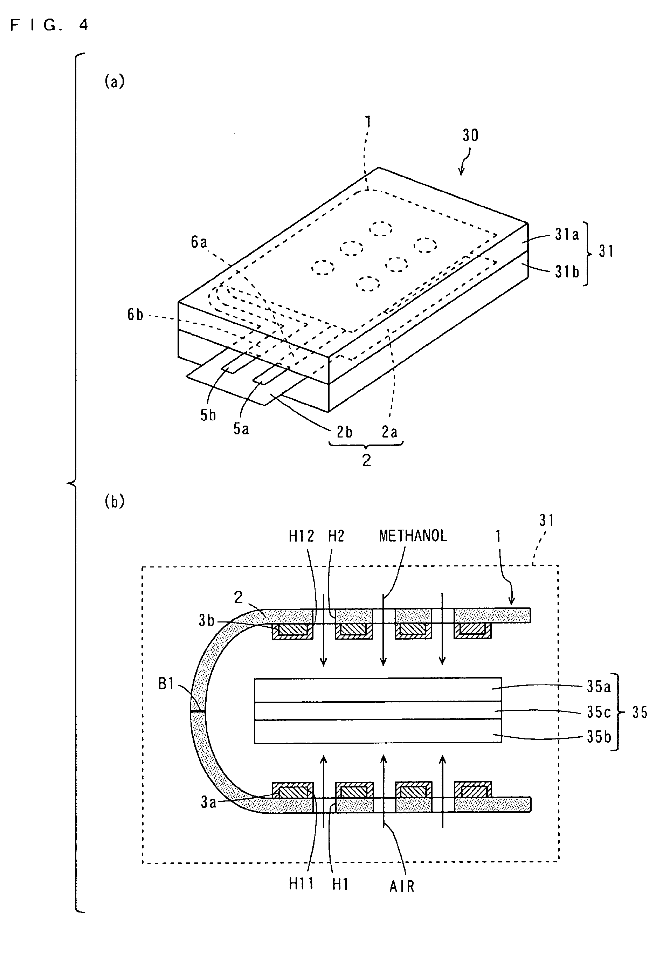

Next, description is made of the fuel cell using the above-described FPC board 1. Fig. 4 (a) is a perspective view showing the appearance of the fuel cell using the above-described FPC board 1, and Fig. 4 (b) is a diagram for use in explaining functions in the fuel cell.

As shown in Fig. 4 (a), the fuel cell 30 includes a rectangular parallelepiped housing 31 composed of half portions 31a, 31b. The FPC board 1 is sandwiched between the half portions 31a, 31b while being bent along the bend portion B1 of Fig. 1 with the one surface on which the conductor layer 3 (Fig. 1) and the coating layers 6a, 6b are formed as its inner side.

The second insulating portion 2b of the base insulating layer 2 of the FPC board 1 is outwardly extracted from a clearance between the half portions 31a, 31b. This causes the extraction electrodes 5a, 5b on the second insulating portion 2b to be exposed to the outside of the housing 31. Terminals of various types of external circuits are electrically connected to the extraction electrodes 5a, 5b.

As shown in Fig. 4 (b), an electrode film 35 is arranged between the collector portion 3a and the collector portion 3b of the bent FPC board 1 in the housing 31. The electrode film 35 is composed of a fuel electrode 35a, an air electrode 35b and an electrolyte film 35c. The fuel electrode 35a is formed on one surface of the electrolyte film 35c, and the air electrode 35b is formed on the other surface of the electrolyte film 35c. The fuel electrode 35a of the electrode film 35 faces the collector portion 3b of the FPC board 1, and the air electrode 35b faces the collector portion 3a of the FPC board 1.

Fuel is supplied to the fuel electrode 35a of the electrode film 35 through the openings H2, H12 of the FPC board 1. Note that methanol is used as fuel in the present embodiment. Air is supplied to the air electrode 35b of the electrode film 35 through the openings H1, H11 of the FPC board 1.

In this case, methanol is decomposed into hydrogen ions and carbon dioxide in the fuel electrode 35a, forming electrons. The formed electrons are led to the extraction electrode 5b (Fig. 4 (a)) from the collector portion 3b of the FPC board 1. Hydrogen ions decomposed from methanol pass through the electrolyte film 35c to reach the air electrode 35b. In the air electrode 35b, hydrogen ions and oxygen are reacted while the electrons led to the collector portion 3a from the extraction electrode 5a (Fig. 4 (a)) are consumed, thereby forming water. In this way, electrical power is supplied to the external circuits connected to the extraction electrodes 5a, 5b.

### (4) Effects of the present embodiment

In the FPC board 1 of the present embodiment, the surface of the conductor layer 3 is coated with the coating layers 6a, 6b. Therefore, corrosion of the conductor layer 3 can be prevented even in a state where acid of methanol and the like is in contact with the surface of the FPC board 1 in the fuel cell 30. In addition, the coating layers 6a, 6b include carbon, thereby ensuring electrical conductivity between the electrode film 35 and the conductor layer 3. Moreover, since it is not necessary to use an expensive material such as Au (gold), corrosion of the conductor layer 3 can be prevented at low cost. Furthermore, ion migration of the conductor layer 3 can be prevented by the coating layers 6a, 6b.

In the FPC board 1 of the present embodiment, the extraction electrodes 5a, 5b are provided side by side in the same plane of the common second insulating portion 2b of the base insulating layer 2. Thus, when the FPC board 1 is used in the fuel cell 30, the extraction electrodes 5a, 5b can be easily and accurately aligned with and connected to terminals of external circuits. Accordingly, reliability of connection between the external circuits and the fuel cell 30 is improved.

Note that a material for the base insulating layer 2 is not limited to polyimide. For example, other insulating materials such as polyethylene terephthalate, polyethernitrile and polyethersulfone may be used.

A material for the conductor layer 3 is not limited to copper. For example, other metal materials such as copper alloy and aluminum may be used. Examples of the resin composition containing carbon used for the coating layer 6a, 6b may include epoxy resin containing carbon, polyimide resin containing carbon and the like. Carbon is not limited to carbon black, and various types of carbon materials such as graphite may be used.

### (5) Correspondences between elements in the claims and parts in embodiments

In the following paragraph, non-limiting examples of correspondences between various elements recited in the claims below and those described above with respect to various embodiments of the present invention are explained.

In the above-described embodiment, the base insulating layer 2 is an example of an insulating layer, the one region of the first insulating portion 2a with the bend portion B1 as the boundary is an example of a first region, the other region of the first insulating portion 2a with the bend portion B1 as the boundary is an example of a second region, the second insulating portion 2b is an example of a third region, the collector portion 3a is an example of a first conductor portion, the collector portion 3b is an example of a second conductor potion, the extraction conductor portion 4a is an example of a first extraction portion, the extraction conductor portion 4b is an example of a second extraction portion, the openings H1, H11 are examples of a first through hole, and the openings H2, H12 are examples of a second through hole. In addition, the fuel electrode 35a, the air electrode 35b and the electrolyte film 35c are examples of a cell element.

As each of various elements recited in the claims, various other elements having configurations or functions described in the claims can be also used.

While preferred embodiments of the present invention have been described above, it is to be understood that variations and modifications will be apparent to those skilled in the art.

## Claims

1. A printed circuit board used for a fuel cell, comprising:
an insulating layer;
a conductor layer that is provided on said insulating layer and has a predetermined pattern; and
a coating layer that includes carbon and coats a surface of said conductor layer.

2. The printed circuit board according to claim 1, wherein said coating layer includes a resin composition containing carbon.

3. The printed circuit board according to claim 1 or 2, wherein
said insulating layer has one surface and the other surface while including, on said one surface, first and second regions that are adj acent to each other and a third region that is adj acent to said first region,
said insulating layer can be bent along a bend portion between said first region and said second region such that said first region and said second region face each other,
said conductor layer includes
a first conductor portion formed in said first region of said insulating layer,
a second conductor portion formed in said second region of said insulating layer,
a first extraction portion formed so as to extend from said first conductor portion to reach said third region of said insulating layer, and
a second extraction portion formed so as to extend from said second conductor portion to reach said third region of said insulating layer, and
said coating layer includes
a first coating portion that coats said first conductor portion and said first extraction portion, and
a second coating portion that coats said second conductor portion and said second extraction portion.

4. The printed circuit board according to claim 3, wherein
a first through hole is formed so as to penetrate said first region of said insulating layer and said first conductor portion of said conductor layer, and
a second through hole is formed so as to penetrate said second region of said insulating layer and said second conductor portion of said conductor layer.

5. A fuel cell comprising:
a printed circuit board;
a cell element; and
a housing that houses said printed circuit board and said cell element, wherein
said printed circuit board includes
an insulating layer having one surface and the other surface while including, on said one surface, first and second regions that are adjacent to each other and a third region that is adjacent to said first region,
a first conductor portion formed in said first region of said insulating layer,
a second conductor portion formed in said second region of said insulating layer,
a first extraction portion formed so as to extend from said first conductor portion to reach said third region of said insulating layer,
a second extraction portion formed so as to extend from said second conductor portion to reach said third region of said insulating layer, and
a coating layer that includes carbon and coats surfaces of said first and second conductor portions and surfaces of said first and second extraction portions,
a bend portion is provided at a boundary between said first region and said second region of said insulating layer, said cell element is arranged between said first and second regions in a state where said first and second regions of said insulating layer of said printed circuit board are bent along said bend portion with said one surface as an inner side, and
said third region of said insulating layer is outwardly extracted from said housing such that at least part of said first extraction portion and at least part of said second extraction portion are exposed to the outside of said housing.
